Europäisches Patentamt

European Patent Office

Office européen des brevets

(19)

(11)     EP 0 678 960 B1

(12)     **FASCICULE DE BREVET EUROPEEN**

(45) Date de publication et mention
de la délivrance du brevet:
**24.01.2001   Bulletin 2001/04**

(51) Int Cl.⁷: **H02H 1/04**, G01R 19/25,
G01R 15/18

(21) Numéro de dépôt: **95410024.4**

(22) Date de dépôt: **04.04.1995**

(54) **Procédé et dispositif de correction d'un signal de courant**

Verfahren und Einrichtung zur Korrektur eines Stromsignals

Method and apparatus for correcting a current signal

(84) Etats contractants désignés:
**BE DE ES GB IT**

(30) Priorité: **21.04.1994   FR 9404924**

(43) Date de publication de la demande:
**25.10.1995   Bulletin 1995/43**

(73) Titulaire: **Schneider Electric Industries SA
92500 Rueil-Malmaison (FR)**

(72) Inventeurs:
• **Suptitz, Eric
F-38050 Grenoble Cedex 09 (FR)**
• **Blanchard, Pierre
F-38050 Grenoble Cedex 09 (FR)**
• **Collier, James
F-38050 Grenoble Cedex 09 (FR)**

(74) Mandataire: **Jouvray, Marie-Andrée et al
Schneider Electric SA,
Sce. Propriété Industrielle
38050 Grenoble Cédex 09 (FR)**

(56) Documents cités:
**EP-A- 0 570 304**

• **SOVIET PATENT ABSTRACTS Section EI, Week
9001 14 Février 1990 Derwent Publications Ltd.,
London, GB; Class S01, AN 90-005998 & SU-A-1
488 909 (NOVCH POLY) , 23 Juin 1989**
• **SOVIET PATENT ABSTRACTS Section EI, Week
8848 18 Janvier 1989 Derwent Publications Ltd.,
London, GB; Class X13, AN 88-344991 & SU-A-1
398 014 (NOVCH POLY) , 23 Mai 1988**

EP 0 678 960 B1

**Description**

L'invention concerne un procédé et un dispositif de correction d'un signal de courant déformé ainsi qu'un déclencheur électronique comportant un tel dispositif.

En courant alternatif, les capteurs de courant sont généralement des transformateurs de courant comportant un circuit magnétique. Dans un enroulement primaire circule le courant à mesurer et dans un enroulement secondaire circule un courant représentatif du courant à mesurer. Les capteurs de courant sont, de manière connue, intégrés dans des déclencheurs électroniques pour disjoncteurs. Dans ce type de produit, des signaux représentatifs du courant dans l'enroulement secondaires sont utilisés par une unité de traitement pour effectuer une protection selon des courbes de déclenchement prédéterminées. L'unité de traitement calcule la valeur efficace du courant et le carré du courant, pour les utiliser dans des courbes de protection thermique.

Les déclencheurs électroniques doivent fonctionner à des niveaux de courant très supérieurs à leur courant nominal. Mais il arrive que pour certains calibres de disjoncteurs, les transformateurs de courant n'aient pas une réponse linéaire sur toute la gamme de mesure et de protection du déclencheur. Ces défauts sont dûs à la saturation du circuit magnétique des transformateurs à fort niveau de courant et à un manque de magnétisation à très bas niveau de courant. La valeur du courant secondaire devient plus faible que la valeur théorique et la forme du courant est différente. Le changement de forme du courant conduit, sur une grande plage de fonctionnement, à des réponses en courant des transformateurs plus dégradées en valeur efficace ou en valeur moyenne qu'en valeur crête.

Certaines solutions connues permettent de corriger partiellement ce type de défaut, par exemple le brevet US-4.870.532 propose un dispositif qui fait varier l'impédance de mesure en fonction du courant fourni par les transformateurs de courant. Cette solution s'applique aux valeurs crêtes ou instantanées du courant et nécessite des composants électroniques de puissance capables de laisser passer le courant des transformateurs de courant.

Le document un EP-A-0570304 décrit un procédé et un dispositif de correction d'un signal de courant déformé, ainsi qu'un déclencheur électronique comportant un dispositif de correction, pour corriger des valeurs de courant en fonction de la valeur efficace d'un signal de courant d'entrée.

L'invention a pour but procurer un procédé et un dispositif de correction alternatifs permettant de corriger des signaux de courant déformés par des transformateurs de courant, ainsi que l'application de ce procédé dans un déclencheur électronique.

Selon l'invention, le procédé comporte des cycles de correction successifs, chaque cycle comportant :

- la mise en mémoire d'une grandeur de sortie,
- la mesure d'une grandeur d'entrée représentative du signal du courant déformé,
- la détermination d'une la grandeur limitée représentative de la différence entre la grandeur de sortie mise en mémoire et une valeur de limitation prédéterminée,
- la détermination d'une nouvelle valeur de la grandeur de sortie de telle sorte que la grandeur de sortie présente une variation à la décroissance inférieure ou égale à la valeur de limitation prédéterminée.

Dans un mode préférentiel de réalisation, la détermination de la nouvelle valeur de sortie comporte :

- la détermination de la différence entre la grandeur de sortie mise en mémoire et la grandeur d'entrée mesurée,
- la comparaison de ladite différence et la valeur de limitation prédéterminée,
- la production de la nouvelle valeur de la grandeur de sortie égale à la grandeur d'entrée mesurée si ladite différence est inférieure ou égale à ladite valeur de limitation,
- la production de la nouvelle valeur la grandeur de sortie, égale à la grandeur limitée si ladite différence est supérieure à la valeur de limitation.

Selon un développement du mode de réalisation, chaque cycle de correction correspond à un cycle d'échantillonnage de la grandeur d'entrée.

Dans un mode particulier de réalisation, la mesure de la grandeur d'entrée comporte une élévation à une puissance supérieure à un du signal de courant déformé.

Selon un développement de l'invention, le procédé comporte la détermination de la valeur de limitation en fonction de la fréquence de la grandeur d'entrée.

L'invention concerne également un dispositif de correction pour la mise en oeuvre du procédé et un déclencheur comportant un tel dispositif.

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :

La figure 1 représente le schéma simplifié d'un déclencheur de type connu.

La figure 2 illustre des signaux de courant théoriques et déformés.

Les figures 3 et 4 illustrent des signaux de courant corrigés par un procédé selon deux modes de mise en oeuvre de l'invention.

La figure 5 représente le schéma d'un déclencheur selon un premier mode de réalisation.

Les figures 6 et 7 montrent deux modes de réalisation d'un circuit de correction selon l'invention.

La figure 8 montre un organigramme d'un circuit de correction pouvant être utilisé dans le déclencheur de la figure 5.

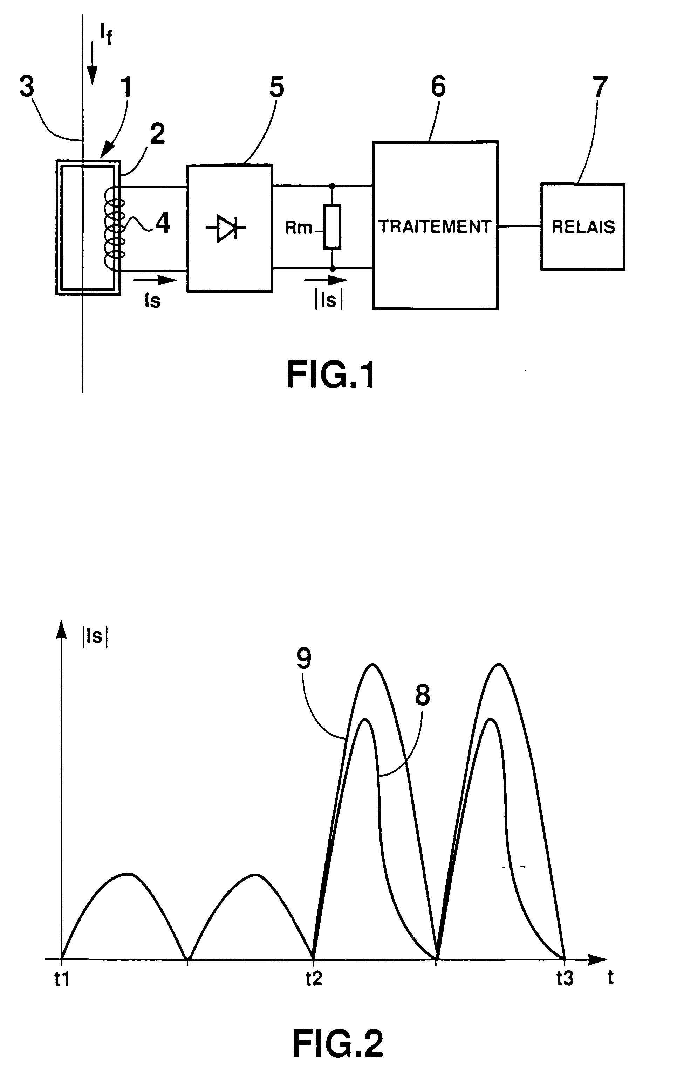

La figure 1 montre le schéma bloc d'un déclencheur électronique de type connu comportant un transformateur de courant 1. Le transformateur 1 comporte un circuit magnétique 2 traversé par un conducteur principal conduisant le courant primaire Ip. Un enroulement secondaire 4, bobiné sur le circuit magnétique, fournit un courant secondaire Is proportionnel au courant primaire Ip. L'enroulement secondaire est connecté à des entrées d'un circuit 5 de redressement. Une résistance de mesure Rm, connectée à des sorties du circuit de redressement, reçoit un courant redressé. Un circuit de traitement 6 comporte des entrées connectées à la résistance de mesure Rm et une sortie connectée à un relais 7 de déclenchement. Le circuit de traitement reçoit sur ses entrées un signal représentatif de la valeur absolue ou redressée du courant secondaire Is et fournit un signal de déclenchement en fonction des valeurs dudit courant.

Le déclencheur électronique doit fonctionner avec une grande dynamique de mesure pouvant s'étendre entre le dixième et quinze fois la valeur du courant nominal. Cependant, de manière générale, les capteurs ou transformateurs de courant génèrent des courants secondaires déformés à faible niveau de courant et à haut niveau de courant. Les déformations à bas niveau sont dûes au manque de magnétisation alors que à haut niveau les déformations sont provoquées par la saturation du circuit magnétique.

Des courbes représentant des courants secondaires redressés sont illustrées sur la figure 2. Entre des instants t1 et t2 le courant secondaire redressé |Is| a une valeur proche de sa valeur nominale et ne présente pas de déformation. Entre l'instant t2 et un instant t3 le courant est très élevé et déformé. Une courbe 8 représente un courant déformé de valeur moyenne ou efficace inférieure à la valeur que peut donner un courant théorique sinusoïdal représenté par une courbe 9. Le courant déformé de la courbe 8 redescend plus tôt vers une valeur nulle, avec au départ au moins une variation plus rapide que celle du courant théorique de la courbe 9.

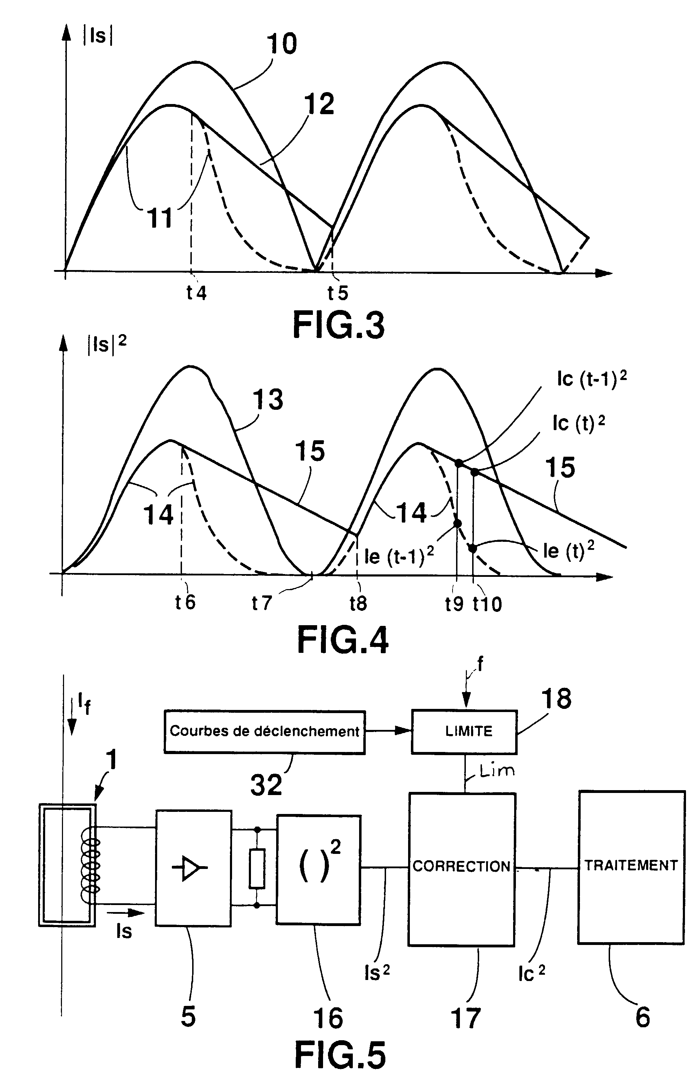

Un premier mode de mise en oeuvre d'un procédé de correction est illustré à la figure 3. Une courbe 10 représente un signal sinusoïdal théorique redressé et une courbe 11, un signal déformé représentatif de la valeur absolue courant |Is| mesuré. Selon ce procédé de correction, un signal de correction représenté par une courbe 12 est substitué au signal déformé 11 lorsque celui-ci commence à décroître trop rapidement vers zéro puis tant qu'il reste inférieur, à une valeur de limitation près, audit signal de correction 12. Sur la figure c'est le cas entre des instants t4 et t5. De cette manière le procédé de correction limite la décroissance du signal appliqué au circuit de traitement et compense les erreurs des valeurs moyennes ou efficaces du courant.

Le procédé de correction peut s'appliquer à toutes les grandeurs représentatives du courant Is, par exemple sa valeur absolue |Is| comme sur la figure 3, ou son carré $Is^2$ comme sur la figure 4. Une courbe 13 représente la courbe théorique du carré du courant lorsque celui-ci est sinusoïdal. Une courbe 14 représente la courbe déformée du carré du courant mesuré et une courbe 15 représente une courbe corrigée. A partir de l'instant t6 le signal 15, ayant une décroissance stable et contrôlée par une valeur de limitation Lim, est substitué au signal 14 ayant une décroissance plus rapide que le signal 15. La substitution du signal 14 par le signal 15 reste active tant que le signal 14 reste inférieur au signal 15. A un instant t7, correspondant au début d'une nouvelle période, les signaux 13 et 14 recommencent à croître. Puis, à un instant t8, le signal 14 devient supérieur au signal 15 et est de nouveau utilisé par le circuit de traitement.

Sur la figure 4 des échantillons de signaux Ie $(t)^2$, Ic$(t)^2$, Ic$(t-1)^2$ illustrent le procédé de correction du signal $Is^2$. A un instant t9 un échantillon Ie $(t-1)^2$ est corrigé et remplacé par un échantillon Ic$(t-1)^2$ de valeur plus élevée. La valeur de l'échantillon Ic$(t-1)^2$ est stockée pour être réutilisée lors de la correction d'un échantillon suivant Ie$(t)^2$ à un instant t10. L'échantillon Ie$(t)^2$ étant très inférieur à l'échantillon stocké Ic$(t-1)^2$, le procédé de correction remplacera l'échantillon Ie$(t)^2$ de la courbe 14 par un échantillon Ic$(t)^2$ égal à Ic$(t-1)^2$ - Lim de la courbe 15.

Un schéma d'un déclencheur comportant un dispositif mettant en oeuvre un procédé de correction du carré du courant $Is^2$ est représenté sur la figure 5. Le signal représentatif du courant mesuré redressé est appliqué à l'entrée d'un module 16 calculant le carré du courant mesuré. Une sortie du module 16 fournissant un signal $Is^2$ est connectée à une première entrée d'un dispositif de correction 17. Le dispositif 17 reçoit également sur une seconde entrée une valeur de limitation Lim prédéterminée mémorisée dans un circuit 18. Une sortie du circuit de correction 17, connectée à l'entrée du circuit de traitement 6, fournit un signal $I^2c$ représentatif du courant corrigé selon le procédé de correction.

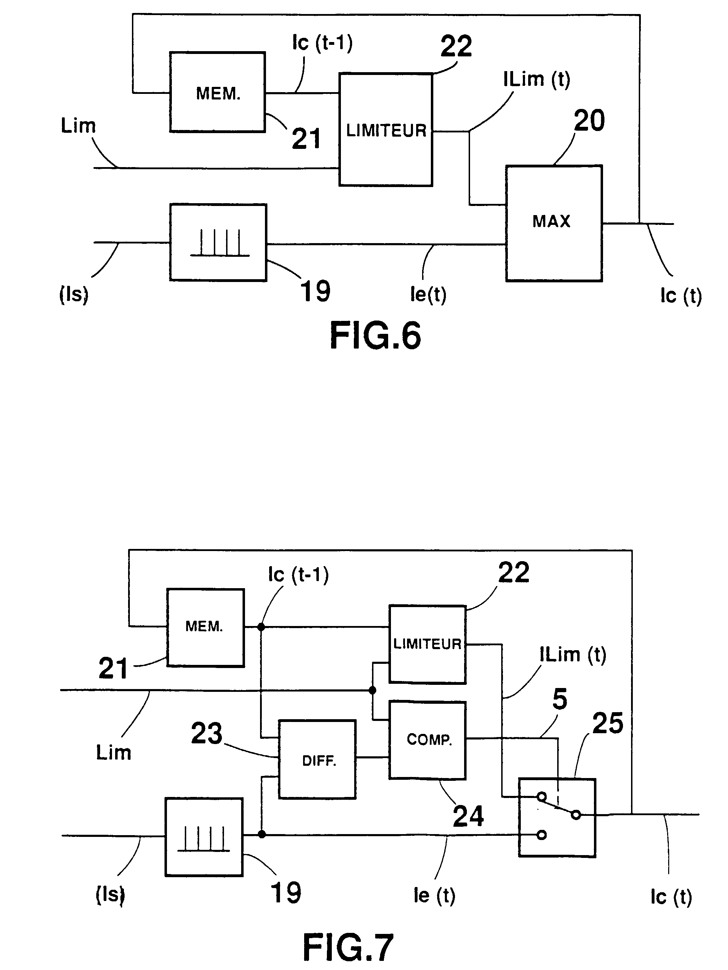

Une structure du circuit de correction, selon un premier mode de réalisation, appliquée à la valeur absolue du courant mesuré, est représentée sur la figure 6. La première entrée reçoit un signal |Is| représentatif de la valeur absolue du courant secondaire. La seconde entrée reçoit la valeur de limitation Lim et la sortie fournit le signal corrigé Ic. Le circuit de correction comporte un échantillonneur 19, un détecteur de maximum 20, un circuit de mémorisation 21 et un limiteur 22. L'échantillonneur 19 a une entrée connectée à la première entrée du circuit de correction et une sortie connectée à une première entrée du détecteur de maximum. Il fournit sur sa sortie un signal échantillonné Ie représentatif du signal |Is| d'entrée. Le détecteur de maximum 20 a une seconde entrée connectée à une sortie du limiteur 22 pour recevoir un signal ILim (t). Une sortie du détecteur de maximum, correspondant à la sortie du circuit de correction, est connectée à une entrée du circuit de mémorisation 21. Le signal de sortie du détecteur de maximum 20 est constitué par un échantillon correspondant à la valeur la plus élevée choisie entre les signaux Ie et ILim appliqués respectivement sur la première et la seconde entrée. Une sortie du circuit de mémorisation 21 est connectée à une première entrée du limiteur 22. Le circuit de mémorisation garde la valeur du dernier échantillon du signal de sortie Ic(t). Il fournit au limiteur un signal Ic (t-1) représentatif de la valeur précédente de Ic(t). Le limiteur a une seconde entrée correspondant à la seconde entrée du circuit de correction pour recevoir la valeur de limitation Lim. Le limiteur fournit au détecteur de maximum le signal ILim (t) correspondant à la différence entre la valeur précédente du signal de sortie du circuit de correction Ic(t-1), présent sur la première entrée, et la valeur de limitation Lim. La valeur d'un échantillon de ILim(t) à un instant t peut s'écrire :

$$ILim(t) = Ic(t-1) - Lim \qquad (1)$$

et la valeur de Ic(t) :

$$Ic(t) = MAX ( Ie(t) ; I\ Lim(t)) \qquad (2)$$

Ainsi, à chaque échantillon, un signal ILim est calculé en diminuant la valeur précédente du signal corrigé Ic(t-1) d'une valeur prédéterminée lim. Si la valeur ILim ainsi calculée est supérieure à la valeur Ie mesurée, alors le signal de correction est égal à la valeur calculée. Par contre, tant que la valeur Ie mesurée est supérieure à la valeur calculée, le signal de correction Ic est identique à la valeur mesurée Ie. Le circuit de correction de la figure 6 permet ainsi la mise en oeuvre du procédé de correction représenté à la figure 3.

Un autre mode de réalisation, plus complexe, du circuit de correction est représenté sur la figure 7. Le circuit comporte, comme celui de la figure 6, un échantillonneur 19, un circuit de mémorisation 21 et un limiteur 22. Le circuit de maximum de la figure 6 est supprimé et le circuit de correction comporte un circuit différentiateur 23, un circuit de comparaison 24 et un circuit de sélection 25. Le circuit différentiateur 23 comporte deux entrées, une première connectée à la sortie de l'échantillonneur 19 et une seconde à la sortie du circuit de mémorisation 21. Une sortie du circuit 23 est connectée à une première entrée du circuit de comparaison 24. Une seconde entrée du circuit de comparaison 24 reçoit la valeur de limitation Lim et une sortie du circuit 24 reliée au circuit de sélection 25, lui envoie un signal S de contrôle. Une première entrée du circuit de sélection 25 connectée à la sortie de l'échantillonneur 19 reçoit le signal Ie(t) et une seconde entrée connectée à la sortie du limiteur 22 reçoit le signal ILim (t). Une sortie du circuit de sélection 25, correspondant à la sortie du circuit de correction, fournit le signal Ic(t) représentatif de la valeur du courant corrigé. Le circuit différentiateur calcule la différence entre un échantillon Ie(t) provenant de l'échantillonneur 19 et l'échantillon corrigé précédent Ic (t-1) stocké dans le circuit de mémorisation 21. L'expression du signal de sortie du différenciateur est Ic(t-1) - Ie(t). Le signal de sortie du circuit 23 est ensuite comparé à la valeur de limitation Lim dans le circuit de comparaison 24. Si la différence Ic(t-1) - Ie(t) est supérieure à la valeur de limitation Lim, le signal de contrôle S positionne le circuit de sélection 25 de manière à déconnecter sa première entrée de sa sortie et à relier sa seconde entrée recevant le signal ILim à sa sortie. Le signal de courant limité ILim (t) est alors substitué au signal d'entrée Ic(t). Sous une forme différente, ce circuit réalise la même fonction que le circuit de la figure 6.

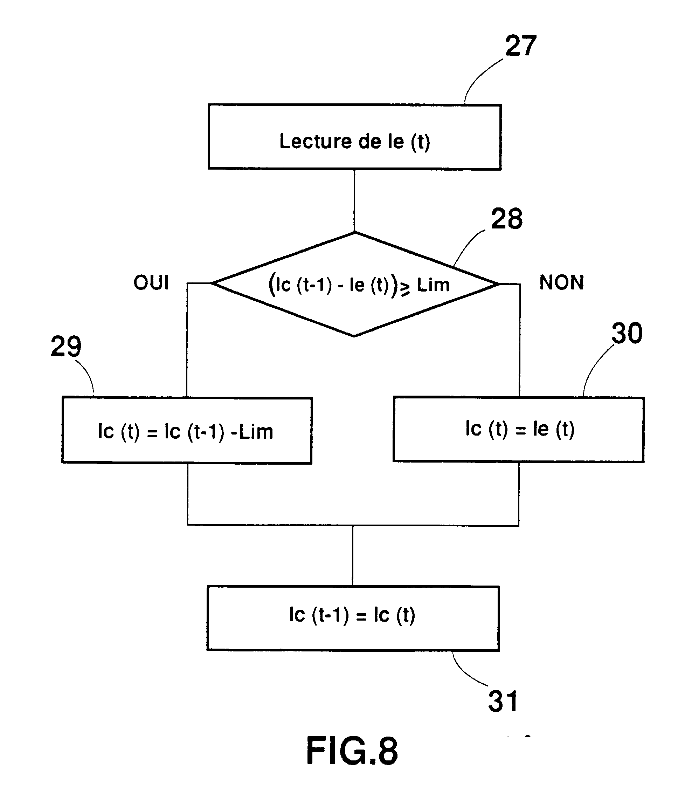

Le circuit de correction 17 peut comporter un microprocesseur programmé de manière à réaliser les différentes étapes du procédé de correction. Un organigramme correspondant est représenté sur la figure 8. A une étape 27 un échantillon Ie(t) est lu. Dans une étape 28 la différence entre une valeur Ic(t-1) d'un échantillon de sortie précédent stocké et la valeur Ie(t) est comparée à la valeur de limitation Lim. Si la différence est supérieure ou égale à lim (sortie oui) alors (étape 29), la valeur de sortie Ic(t) est égale à la différence entre la valeur Ic(t-1) mémorisée et la valeur de limitation Lim, soit Ic(t) = Ic(t-1) - Lim. Dans le cas contraire (étape 30) le signal de sortie Ic(t) est égal au signal d'entrée Ie(t). Ensuite, dans une étape 31, le signal de sortie Ic(t) est stocké de manière à être utilisé comme échantillon précédent Ic(t-1) dans le cycle d'échantillonnage suivant. Le signal de sortie Ic(t) est ensuite utilisé par le circuit de traitement du déclencheur.

La valeur de la limitation est déterminée en fonction de plusieurs paramètres dont les principaux sont : la période d'échantillonnage, la fréquence du courant, le type de courbe de déclenchement ou la puissance à laquelle le courant est élevé, l'amplitude maximale et nominale du signal représentatif du courant et le taux de déformation. Par exemple, pour un déclencheur pouvant mesurer une amplitude maximale égale à 11 fois l'amplitude nominale d'un courant alternatif de 50 Hz, et ayant un dispositif d'échantillonnage fonctionnant à une période de 625 μS, la valeur de la limite peut être de l'ordre de 6 % de l'amplitude maximale si la correction est effectuée sur le carré du courant (figure 4).

Dans des déclencheurs électroniques complexes, la valeur de la limite peut être déterminée automatiquement en fonction de la fréquence du courant ou du type de courbes de déclenchement.

Dans ce cas, le circuit 18, représenté à la figure 5 peut comporter deux entrées supplémentaires. Sur l'une de ces entrées supplémentaires est appliqué un signal représentatif de la fréquence du courant mesurée par les capteurs de courant. L'autre entrée supplémentaire est connectée à un circuit 32 de sélection du type de courbes de déclenchement. Dans les modes de réalisation représentés sur les figures, la correction est effectuée soit sur |Is| soit sur Is². Il est possible d'utiliser le même procédé de correction sur |Is|$^P$, où P est supérieur ou égal à 1 par exemple 1,8 ; 3 ou 4. Dans ce cas le circuit 32 fournit cette valeur de P au circuit 18 qui en tient compte pour déterminer la valeur de limitation.

Les corrections décrites ci-dessus s'appliquent essentiellement aux courants déformés par saturation des transformateurs, mais elles peuvent être utilisées de la même manière pour des corrections d'un signal déformé par manque de magnétisation à bas courant. Les moyens pour mettre en oeuvre le procédé de correction peuvent être réalisés sous forme de circuits électroniques ou être intégrés dans un programme et traités par un microprocesseur. Dans un déclencheur multipolaire ayant un capteur de courant par pôle à protéger, les circuits de correction, d'élévation à une puissance, ou de traitement peuvent être communs à tous les courants secondaires.

La valeur de limitation est de manière préférentielle fixe et constante bien qu'une valeur de limitation variable puisse, dans certains cas, convenir pour la correction. Par exemple, la valeur de limitation peut être dépendante d'une valeur représentative du courant suivant des fonctions non linéaires.

## Revendications

1. Procédé de correction d'un signal de courant déformé caractérisé en ce qu'il comporte des cycles de correction successifs, chaque cycle comportant :

   - la mise en mémoire (21, 31) d'une grandeur de sortie (12, 15, Ic, Ic²)

   - la mesure (19, 27) d'une grandeur d'entrée (11, 14, Is, Is²) représentative du signal du courant déformé,

   - la détermination (22, 29) d'une grandeur limitée (ILim) représentative de la différence entre la grandeur de sortie (Ic(t-1), 12,15) mise en mémoire et une valeur de limitation prédéterminée (Lim),

   - la détermination (20, 22, 24, 25, 28, 29, 30) d'une nouvelle valeur de la grandeur (Ic(t) 11, 12, 14, 15) de sortie de telle sorte que la grandeur de sortie présente une variation à la décroissance inférieure ou égale à la valeur de limitation prédéterminée (Lim).

2. Procédé selon la revendication 1 caractérisé en ce que la détermination de la nouvelle valeur de sortie comporte :

   - la détermination (23, 28) de la différence entre la grandeur de sortie (Ic(t-1), 12, 15) mise en mémoire et la grandeur d'entrée mesurée,

   - la comparaison (24, 28) de ladite différence et la valeur de limitation prédéterminée (Lim),

   - la production (30) de la nouvelle valeur de la grandeur de sortie (Ic(t)) égale à la grandeur d'entrée (Is, le) mesurée si ladite différence est inférieure ou égale à ladite valeur de limitation (Lim),

   - la production (29) de la nouvelle valeur la grandeur de sortie (Ic(t)) égale à la grandeur limitée (ILim) si ladite différence est supérieure à la valeur de limitation (Lim).

3. Procédé selon l'une des revendications 1 et 2 caractérisé en ce que chaque cycle de correction correspond à un cycle d'échantillonnage de la grandeur d'entrée.

4. Procédé selon l'une quelconque des revendications 1 à 3 caractérisé en ce que la mesure de la grandeur d'entrée comporte une élévation (16) à une puissance supérieure à un du signal de courant déformé.

5. Procédé selon l'une quelconque des revendications 1 et 4 caractérisé en ce qu'il comporte la détermination (18) de la valeur de limitation (Lim) en fonction de la fréquence (f) de la grandeur d'entrée.

6. Dispositif de correction pour la mise en oeuvre du procédé selon l'une quelconque des revendications 1 à 5 comportant :

   - une entrée recevant la grandeur d'entrée (Is),
   - une sortie fournissant la grandeur de sortie (Ic)

   caractérisé en ce qu'il comporte :

   - des moyens de mémorisation (21, 31) connectés à la sortie pour mémoriser la grandeur de sortie,

   - des moyens de mesure (19, 27) connectés à l'entrée pour mesurer la grandeur d'entrée représentative du signal du courant déformé,

   - des moyens de détermination (22, 29) d'une grandeur limitée (ILim) connectés aux moyens de mémorisation et à une entrée représentative d'une valeur de limitation prédéterminée (Lim),

- des moyens de détermination (22, 20) de la grandeur de sortie (Ic) connectés aux moyens de mémorisation, aux moyens de mesure, aux moyens de détermination d'une grandeur limitée, et à la sortie pour produire une nouvelle valeur de la grandeur (Ic) de sortie de telle sorte que la grandeur de sortie présente une variation à la décroissance inférieure ou égale à la valeur de limitation prédéterminée (Lim).

7. Dispositif de correction selon l'une quelconque des revendications 1 à 6 caractérisé en ce que les moyens de détermination de la grandeur de sortie comportent :

 - des moyens de détermination de différence (23, 28) connectés aux moyens de mémorisation et aux moyens de mesure pour calculer la différence entre la grandeur de sortie mise en mémoire et la grandeur d'entrée mesurée,

 - des moyens de comparaison (24, 28) connectés aux moyens de détermination de différence pour comparer la dite différence et la valeur de limitation prédéterminée (Lim).

 - des moyens de production (20, 22, 25, 29, 30) connectés aux moyens de comparaison, aux moyens de mesures, aux moyens de mémorisation et à la sortie pour produire la nouvelle valeur de la grandeur de sortie égale à la nouvelle grandeur d'entrée mesurée si ladite différence est inférieure ou égale à ladite valeur de limitation (Lim), ou égale à la grandeur limitée (ILim) si ladite différence est supérieure à la valeur de limitation (Lim).

8. Déclencheur électronique comportant une unité de traitement (6), des capteurs (1) de courant et des moyens de correction (17) connectés aux capteurs de courant et à l'unité de traitement, caractérisé en ce que les moyens de correction comportent un dispositif de correction selon l'une quelconque des revendications 6 à 7.

9. Déclencheur électronique selon la revendication 8 caractérisé en ce qu'il comporte

 - des moyens (18) de détermination de la valeur de limitation (Lim) connectés au dispositif de correction,

 - des moyens d'élévation (16) connectés à l'entrée du dispositif de correction pour élever la grandeur d'entrée à une puissance supérieure à un,

 - et des moyens de détermination de puissance (32) connectés aux seconds moyens (18) de détermination de la valeur de limitation et aux moyens d'élévation (16) pour déterminer la valeur de ladite puissance.

**Patentansprüche**

1. Verfahren zur Korrektur eines verformten Stromsignals, dadurch gekennzeichnet, daß es aufeinanderfolgende Korrekturzyklen umfaßt und jeder Zyklus folgende Schritte umfaßt:

 - die Abspeicherung (21, 31) einer Ausgangsgröße (12, 15, Ic, Ic$^2$),

 - die Messung (19, 27) einer das verformte Stromsignal abbildenden Eingangsgröße (11, 14, Is, Is$^2$),

 - die Bestimmung (22, 29) einer begrenzten Größe (I Lim), welche die Differenz zwischen der abgespeicherten Ausgangsgröße (Ic(t-1), 12,15) und einem festgelegten Begrenzungswert (Lim) abbildet,

 - die Bestimmung (20, 22, 24, 25, 28, 29, 30) eines neuen Wertes der Ausgangsgröße (Ic(t) 11, 12, 14, 15), derart daß die zeitliche Änderung der Ausgangsgröße im abfallenden Kurventeil kleiner oder gleich dem festgelegten Begrenzungswert (Lim) ist.

2. Verfahren nach Anspruch 1, dadurch gekennzeichnet, daß die Bestimmung des neuen Ausgangswerts folgende Schritte umfaßt:

 - die Bestimmung (23, 28) der Differenz zwischen der abgespeicherten Ausgangsgröße (Ic (t-1), 12, 15) und der gemessenen Eingangsgröße,

 - den Vergleich (24, 28) der genannten Differenz mit dem festgelegten Begrenzungswert (Lim),

 - die Erzeugung (30) des neuen Wertes der Ausgangsgröße (Ic(t)), welcher der gemessenen Eingangsgröße (Is, Ie) entspricht, wenn die genannte Differenz kleiner oder gleich dem genannten Begrenzungswert (Lim) ist,

 - die Erzeugung (29) des neuen Wertes der Ausgangsgröße (Ic(t)), welcher der begrenzten Größe (I Lim) entspricht, wenn die genannte Differenz über dem genannten Begrenzungswert (Lim) liegt.

3. Verfahren nach einem der Ansprüche 1 und 2, dadurch gekennzeichnet, daß jeder Korrekturzyklus einem Abtastzyklus der Eingangsgröße entspricht.

4. Verfahren nach irgendeinem der Ansprüche 1 bis 3, dadurch gekennzeichnet, daß die Messung der Eingangsgröße eine Erhebung (16) des verformten Stromsignals in eine Potenz größer als 1 umfaßt.

5. Verfahren nach irgendeinem der Ansprüche 1 bis 4, dadurch gekennzeichnet, daß es die Bestimmung (18) des Begrenzungswerts (Lim) in Abhängigkeit von der Frequenz (f) der Eingangsgröße umfaßt.

6. Korrekturanordnung zur Anwendung des Verfahrens nach irgendeinem der Ansprüche 1 bis 5 mit

   - einem, mit der Eingangsgröße (Is) beaufschlagten Eingang und
   - einem, die Ausgangsgröße (Ic) bereitstellenden Ausgang,

   dadurch gekennzeichnet, daß sie

   - an den Ausgang angeschlossene Speichermittel (21, 31) zur Speicherung der Ausgangsgröße,

   - an den Eingang angeschlossene Meßmittel (19, 27) zur Messung der, den verformten Strom abbildenden Eingangsgröße,

   - Mittel (22, 29) zur Bestimmung einer begrenzten Größe (I Lim), die an die Speichermittel sowie einen Eingang angeschlossen sind, welcher einen festgelegten Begrenzungswert (Lim) abbildet,

   - sowie an die Speichermittel, die Meßmittel, die Mittel zur Bestimmung einer begrenzten Größe und an den Ausgang angeschlossene Mittel (22, 20) zur Bestimmung der Ausgangsgröße (Ic) umfaßt, um einen neuen Wert der Ausgangsgröße (Ic) zu erzeugen, dessen zeitliche Änderung im abfallenden Kurventeil kleiner oder gleich dem festgelegten Begrenzungswert (Lim) ist.

7. Korrekturanordnung nach irgendeinem der Ansprüche 1 bis 6, dadurch gekennzeichnet, daß die Mittel zur Bestimmung der Ausgangsgröße

   - an die Speichermittel und die Meßmittel angeschlossene Differenzbestimmungsmittel (23, 28) zur Berechnung der Differenz zwischen der gespeicherten Ausgangsgröße und der gemessenen Eingangsgröße,

   - an die Differenzbestimmungsmittel angeschlossene Vergleichsmittel (24, 28) zum Vergleich der genannten Differenz mit dem festgelegten Begrenzungswert (Lim),

   - sowie an die Vergleichsmittel, die Meßmittel, die Speichermittel und den Ausgang angeschlossene Erzeugungsmittel (20, 22, 25, 29, 30) zur Erzeugung des neuen Werts der Ausgangsgröße umfaßt, welcher der neuen, gemessenen Eingangsgröße entspricht, wenn die genannte Differenz kleiner oder gleich dem genannten Begrenzungswert (Lim) ist, bzw. der begrenzten Größe (I Lim ) entspricht, wenn die genannte Differenz größer als der Begrenzungswert (Lim) ist.

8. Elektronischer Auslöser mir einer Verarbeitungsschaltung (6), Meßstromwandlern (1) und an die Meßstromwandler sowie die Verarbeitungsschaltung angeschlossenen Korrekturmitteln (17), dadurch gekennzeichnet, daß die Korrekturmittel eine Korrekturanordnung nach irgendeinem der Ansprüche 6 bis 7 umfassen.

9. Elektronischer Auslöser nach Anspruch 8, dadurch gekennzeichnet, daß er

   - an die Korrekturanordnung angeschlossene Mittel (18) zur Bestimmung des Begrenzungswerts (Lim),

   - an den Eingang der Korrekturanordnung angeschlossene Potenziermittel (16) zur Erhebung der Eingangsgröße in eine Potenz größer als 1 sowie

   - an die zweiten Mittel (18) zur Bestimmung des Begrenzungswerts und die Potenziermittel (16) angeschlossene Potenzbestimmungsmittel (32) zur Bestimmung des Wertes der genannten Potenz umfaßt.

**Claims**

1. A process for correction of a deformed current signal characterized in that it comprises successive correction cycles, each cycle comprising:

   - storing (21, 31) of an output quantity (12, 15, Ic, Ic$^2$),

   - measurement (19, 27) of an input quantity (11, 14, Is, Is$^2$) representative of the deformed current signal,

   - determination (22, 29) of a limited quantity (ILim) representative of the difference between the stored output quantity (Ic(t-1), 12, 15) and a preset limiting value (Lim),

- determination (20, 22, 24, 25, 28, 29, 30) of a new value of the output quantity (Ic(t), 11, 12, 14, 15) in such a way that the output quantity presents a variation with a decrease lower than or equal to the preset limiting value (Lim).

2. The process according to claim 1, characterized in that determination of the new output value comprises:

- determination (23, 28) of the difference between the stored output quantity (Ic(t-1), 12, 15) and the measured input quantity,

- comparison (24, 28) of said difference and the preset limiting value (Lim),

- production (30) of the new value of the output quantity (Ic(t)) equal to the measured input quantity (Is, Ie) if said difference is smaller than or equal to said limiting value (Lim),

- production (29) of the new value of the output quantity (Ic(t)) equal to the limited quantity (ILim) if said difference is greater than the limiting value (Lim).

3. The process according to either one of the claims 1 or 2, characterized in that each correction cycle corresponds to a sampling cycle of the input quantity.

4. The process according to any one of the claims 1 to 3, characterized in that measurement of the input quantity comprises raising (16) of the deformed current signal to a power higher than one.

5. The process according to any one of the claims 1 to 4, characterized in that it comprises determination (18) of the limiting value (Lim) according to the frequency (f) of the input quantity.

6. A correction device for implementation of the process according to any one of the claims 1 to 5 comprising:

- an input receiving the input quantity (Is),
- an output supplying the output quantity (Ic).

characterized in that it comprises:

- means for storage (21, 31) connected to the output to store the output quantity,

- measuring means (19, 27) connected to the input to measure the input quantity representative of the deformed current signal,

- means (22, 29) for determining a limited quantity (ILim) connected to the storage means and to an input representative of a preset limiting value (Lim),

- means (22, 20) for determining the output quantity (Ic) connected to the storage means, to the measuring means, to the means for determining a limited quantity, and to the output to produce a new value of the output quantity (Ic) in such a way that the output quantity presents a variation with a decrease lower than or equal to the preset limiting value (Lim).

7. The correction device according to any one of the claims 1 to 6 characterized in that the means for determining the output quantity comprise:

- means (23, 28) for determining a difference connected to the means for storage and to the measuring means to calculate the difference between the stored output quantity and the measured input quantity,

- means for comparison (24, 28) connected to the means for determining a difference to compare said difference and the preset limiting value (Lim),

- production means (20, 22, 25, 29, 30) connected to the means for comparison, to the measuring means, to the means for storage and to the output to produce the new value of the output quantity equal to the new measured input quantity if said difference is lower than or equal to said limiting value (Lim), or equal to the limited quantity (ILim) if said difference is greater than the limiting value (Lim).

8. An electronic trip device comprising a processing unit (6), current sensors (1) and correction means (17) connected to the current sensors and to the processing unit, characterized in that the correction means comprise a correction device according to either one of the claims 6 to 7.

9. The electronic trip device according to claim 8 characterized in that it comprises:

- means (18) for determining the limiting value (Lim) connected to the correction device,

- raising means (16) connected to the input of the correction device to raise the input quantity to a power greater than one,

- and power determining means (32) connected to the second means (18) for determining the limiting value and to the raising means (16) to determine the value of said power.

FIG.1

FIG.2

EP 0 678 960 B1

FIG.3

FIG.4

FIG.5

**FIG.6**

**FIG.7**

27

Lecture de le (t)

28

OUI   $(Ic\,(t-1) - Ie\,(t)) \geq Lim$   NON

29

$Ic\,(t) = Ic\,(t-1) - Lim$

30

$Ic\,(t) = Ie\,(t)$

$Ic\,(t-1) = Ic\,(t)$

31

FIG.8